# EUROPEAN PATENT APPLICATION

(11) **EP 4 521 588 A1**
(43) Date of publication of application: **12.03.2025**
(21) Application number: 23856473.6
(22) Date of filing: 09.08.2023
(51) Int. Cl.: H02J 7/00

(54) **ENERGY STORAGE SYSTEM AND POWER SUPPLY CONTROL METHOD FOR BATTERY MANAGEMENT SYSTEM**

(30) Priority: 24.08.2022 CN 202211021658
(71) Applicant: Huawei Digital Power Technologies Co., Ltd., Shenzhen, Guangdong 518043 (CN)
(72) Inventor: ZHANG, Chunlei, Shenzhen, Guangdong 518043 (CN); YU, Shijiang, Shenzhen, Guangdong 518043 (CN); WU, Jiajing, Shenzhen, Guangdong 518043 (CN)
(74) Representative: Gill Jennings & Every LLP
(86) International application number: PCT/CN2023/111936
(87) International publication number: WO 2024/041383

(57) **Abstract**

This application provides an energy storage system and a power supply control method for a battery management system. The energy storage system includes a direct current bus, an energy storage module, an alternating current mains module, an energy storage converter module, a power conversion module, and a battery management system. The battery management system includes a container monitoring unit. The power conversion module is configured to: convert an alternating current voltage output by the alternating current mains module or an alternating current voltage output by the energy storage converter module into a first direct current voltage; use, as a second direct current voltage, a maximum voltage among a direct current voltage output by the energy storage module, a bus voltage output by the direct current bus, and the first direct current voltage; and convert the second direct current voltage into a third direct current voltage and a fourth direct current voltage, and separately supply power to the container monitoring unit based on the third direct current voltage and the fourth direct current voltage. According to embodiments of this application, a plurality of power supply devices supply power to the container monitoring unit in the battery management system through two power supply circuits, thereby improving charging efficiency and improving stability of the energy storage system.

## Description

This application claims priority to Chinese Patent Application No. 202211021658.1, filed with the China National Intellectual Property Administration on August 24, 2022 and entitled "ENERGY STORAGE SYSTEM AND POWER SUPPLY CONTROL METHOD FOR BATTERY MANAGEMENT SYSTEM", which is incorporated herein by reference in its entirety.

### TECHNICAL FIELD

This application relates to the field of energy storage technologies, and in particular, to an energy storage system and a power supply control method for a battery management system.

### BACKGROUND

An energy storage system can improve electric energy quality of a grid and effectively utilize renewable energy, and can be widely used in power generation and distribution fields of a power system. In the energy storage system, a battery management system (battery management system, BMS) is used to detect operating states of batteries in the energy storage system, so that consistency of battery states can be maintained, and performance attenuation and safety problems of a battery string caused by battery state differences are avoided. Therefore, how to improve power supply reliability of the BMS is always a technical problem to be resolved by a person skilled in the art.

### SUMMARY

Embodiments of this application disclose an energy storage system and a power supply control method for a battery management system, so that two direct currents of different voltages can be provided for a container monitoring unit in the battery management system by using a plurality of power supply devices, thereby improving charging efficiency and improving stability of the energy storage system.

According to a first aspect, an embodiment of this application provides an energy storage system, including a direct current bus, an energy storage module, an alternating current mains module, an energy storage converter module, a power conversion module, and a battery management system, and the battery management system includes a container monitoring unit. A first input end of the power conversion module is connected to an output end of the alternating current mains module or an output end of the energy storage converter module, a second input end of the power conversion module is connected to an output end of the direct current bus, a third input end of the power conversion module is connected to an output end of the energy storage module, a first output end of the power conversion module is connected to a first input end of the container monitoring unit, and a second output end of the power conversion module is connected to a second input end of the container monitoring unit. In this way, at least one power supply device in the direct current bus, the energy storage module, the alternating current mains module, or the energy storage converter module may supply power to the container monitoring unit in the battery management system, thereby improving reliability of the energy storage system.

The power conversion module is configured to: convert an alternating current voltage output by the alternating current mains module or an alternating current voltage output by the energy storage converter module into a first direct current voltage, use, as a second direct current voltage, a maximum voltage among a direct current voltage output by the energy storage module, a bus voltage output by the direct current bus, and the first direct current voltage, convert the second direct current voltage into a third direct current voltage and a fourth direct current voltage, and separately supply power to the container monitoring unit based on the third direct current voltage and the fourth direct current voltage, where the third direct current voltage is less than the fourth direct current voltage. In this way, the container monitoring unit is first charged by using the small third direct current voltage, so that a charging speed can be improved. Then, the container monitoring unit is charged by using the large fourth direct current voltage, so that charging efficiency can be improved. After the power supply, the container monitoring unit collects a system parameter of the energy storage system or performs data transmission with a system controller of the energy storage system, thereby improving stability of the energy storage system.

In a possible implementation, the power conversion module includes a first power conversion module, a second power conversion module, and a third power conversion module. Input ends of both the first power conversion module and the second power conversion module may be used as the first input end of the power conversion module, the first input end of the power conversion module is connected to the alternating current mains module and the energy storage converter module, a first output end of the first power conversion module is connected to a first input end of the third power conversion module, an output end of the second power conversion module is used as the second output end of the power conversion module, the second output end of the power conversion module is connected to the second input end of the container monitoring unit, a first output end of the third power conversion module is used as a first output end of the power conversion module, and the first output end of the power conversion module is connected to the first input end of the container monitoring unit.

The first power conversion module is configured to: convert the alternating current voltage output by the alternating current mains module or the alternating current voltage output by the energy storage converter module into the first direct current voltage, and supply power to the third power conversion module based on the first direct current voltage; the second power conversion module is configured to: convert the alternating current voltage output by the alternating current mains module or the alternating current voltage output by the energy storage converter module into the third direct current voltage, and supply power to the container monitoring unit based on the third direct current voltage; and the third power conversion module is configured to: use, as the second direct current voltage, the maximum voltage among the direct current voltage output by the energy storage module, the bus voltage output by the direct current bus, and the first direct current voltage, convert the second direct current voltage into the fourth direct current voltage, and supply power to the container monitoring unit based on the fourth direct current voltage. In this way, the alternating current may be converted into the third direct current voltage applicable to the container monitoring unit by using the second power conversion module, and the alternating current may be converted into the fourth direct current voltage applicable to the container monitoring unit by using the first power conversion module and the third power conversion module. Therefore, the container monitoring unit can operate based on the power supply of the third direct current voltage and the fourth direct current voltage respectively, thereby improving power supply efficiency. In addition, input of the fourth direct current voltage is the maximum voltage among the direct current voltage output by the energy storage module, the bus voltage output by the direct current bus, and the first direct current voltage, which helps improve charging efficiency.

In a possible implementation, the power conversion module includes a first power conversion module, a second power conversion module, and a third power conversion module. An input end of the first power conversion module is used as the first input end of the power conversion module, the first input end of the power conversion module is connected to the alternating current mains module or the energy storage converter module, a first output end of the first power conversion module is connected to a first input end of the third power conversion module, a second output end of the first power conversion module is connected to an input end of the second power conversion module, an output end of the second power conversion module is used as the second output end of the power conversion module, the second output end of the power conversion module is connected to the second input end of the container monitoring unit, a first output end of the third power conversion module is used as the first output end of the power conversion module, and the first output end of the power conversion module is connected to the first input end of the container monitoring unit.

The first power conversion module is configured to: convert the alternating current voltage output by the alternating current mains module or the alternating current voltage output by the energy storage converter module into the first direct current voltage, and supply power to the second power conversion module and the third power conversion module based on the first direct current voltage; the second power conversion module is configured to: convert the first direct current voltage into the third direct current voltage, and supply power to the container monitoring unit based on the third direct current voltage; and the third power conversion module is configured to: use, as the second direct current voltage, the maximum voltage among the direct current voltage output by the energy storage module, the bus voltage output by the direct current bus, and the first direct current voltage, convert the second direct current voltage into the fourth direct current voltage, and supply power to the container monitoring unit based on the fourth direct current voltage. In this way, the alternating current may be first converted into the direct current by using the first power conversion module, then the first direct current voltage output by the first power conversion module is converted, by using the second power conversion module, into the third direct current voltage applicable to the container monitoring unit, and the first direct current voltage output by the first power conversion module is converted, by using the third power conversion module, into the fourth direct current voltage applicable to the container monitoring unit. Therefore, the container monitoring unit can operate based on the power supply of the third direct current voltage and the fourth direct current voltage respectively, thereby improving power supply efficiency.

In a possible implementation, the power conversion module further includes a fourth power conversion module. A first input end of the fourth power conversion module is used as the second input end of the power conversion module, the second input end of the power conversion module is connected to the direct current bus, a second input end of the fourth power conversion module is used as the third input end of the power conversion module, the third input end of the power conversion module is connected to the energy storage module, and an output end of the fourth power conversion module is connected to a second input end of the third power conversion module.

The fourth power conversion module is configured to convert a larger voltage in the direct current voltage output by the energy storage module and the bus voltage output by the direct current bus into a fifth direct current voltage; and the third power conversion module is configured to use a maximum voltage in the fifth direct current voltage and the first direct current voltage as the second direct current voltage. In this way, the maximum fifth direct current voltage may be first selected from the direct currents provided by the energy storage module and the direct current bus, and the first direct current voltage into which the alternating current voltage output by the alternating current mains module or the alternating current voltage output by the energy storage converter module is converted is obtained. Then, the maximum direct current voltage is selected from the fifth direct current voltage and the first direct current voltage as the second direct current voltage, so that power can be supplied to the battery management system based on the second direct current voltage, and charging efficiency can be improved.

In some possible implementations, if the alternating current mains module, the energy storage converter module, the direct current bus, and the energy storage module all operate normally, the first direct current voltage into which the alternating current provided by the alternating current mains module or the energy storage converter module is converted is greater than the bus voltage output by the direct current bus, and the bus voltage output by the direct current bus is greater than the direct current voltage output by the energy storage module. In this way, when there is the alternating current, the alternating current mains module or the energy storage converter module may be preferably used to supply power to the battery management system. When there is no alternating current, the direct current bus can be used to supply power to the battery management system. When there is no direct current bus, the energy storage module is used to supply power to the battery management system. No uninterruptible power supply (uninterruptible power supply, UPS) is used in the foregoing power supply strategy, which can reduce costs of the energy storage system.

In a possible implementation, the battery management system further includes a battery control unit, the third power conversion module includes a first power conversion unit, and an input end of the first power conversion unit is used as an input end of the third power conversion module, for example, a first input end, a second input end, and the like. The first input end may be connected to an output end of the first power conversion module, and the second input end may be connected to an output end of the fourth power conversion module. Alternatively, the first input end may be connected to the output end of the fourth power conversion module, and the second input end may be connected to the output end of the first power conversion module. A first output end of the first power conversion unit is used as a second output end of the third power conversion module, the second output end of the third power conversion module is connected to an input end of the battery control unit, a second output end of the first power conversion unit is used as the first output end of the third power conversion module, and the first output end of the third power conversion module is connected to the first input end of the container monitoring unit.

The first power conversion unit is configured to: convert the second direct current voltage into the fourth direct current voltage, and supply power to the container monitoring unit based on the fourth direct current voltage; and the first power conversion unit is further configured to: convert the second direct current voltage into the third direct current voltage, and supply power to the battery control unit based on the third direct current voltage. In this way, a same power conversion unit separately supplies power to the container monitoring unit and the battery control unit in the battery management system, which improves power supply efficiency of the battery management system and helps improve stability of the energy storage system. After the power is supplied to the battery control unit, the battery control unit can detect battery rack parameters of battery racks, and control charging and discharging of battery packs in the battery racks based on the battery rack parameters of battery racks, to balance currents and voltages of the battery racks.

In a possible implementation, the battery management system further includes a battery control unit, the third power conversion module includes a second power conversion unit and a third power conversion unit, and input ends of both the second power conversion unit and the third power conversion unit are used as an input end of the third power conversion module, for example, a first input end, a second input end, and the like. An output end of the second power conversion unit is used as a first output end of the third power conversion module, the first output end of the third power conversion module may be connected to the first input end of the container monitoring unit, an output end of the third power conversion unit is used as a second output end of the third power conversion module, and the second output end of the third power conversion module is connected to an input end of the battery control unit.

The second power conversion unit is configured to: convert the second direct current voltage into the fourth direct current voltage, and supply power to the container monitoring unit based on the fourth direct current voltage; and the third power conversion unit is configured to: convert the second direct current voltage into the third direct current voltage, and supply power to the battery control unit based on the third direct current voltage. In this way, a separate power conversion unit is used to supply power to the container monitoring unit in the battery management system, and a separate power conversion unit is used to supply power to the battery control unit in the battery management system, which helps improve stability of the energy storage system. After the power is supplied to the battery control unit, the battery control unit can detect battery rack parameters of battery racks, and control charging and discharging of battery packs in the battery racks based on the battery rack parameters of battery racks, to balance currents and voltages of the battery racks.

In a possible implementation, the battery management system further includes a battery management unit, the third power conversion module further includes a fourth power conversion unit, and an input end of the fourth power conversion unit is used as the input end of the third power conversion module, for example, a first input end, a second input end, and the like. The first input end may be connected to the output end of the first power conversion module, and the second input end may be connected to the output end of the fourth power conversion module. Alternatively, the first input end may be connected to the output end of the fourth power conversion module, and the second input end may be connected to the output end of the first power conversion module. An output end of the fourth power conversion unit is used as a third output end of the third power conversion module, and the third output end of the third power conversion module is connected to an input end of the battery management unit. The fourth power conversion unit is configured to: convert the second direct current voltage into the third direct current voltage, and supply power to the battery management unit based on the third direct current voltage. In this way, the fourth power conversion unit in the third power conversion module in the power conversion module may convert the maximum voltage provided by the energy storage module, the direct current bus, and the alternating current mains module or the energy storage converter module into the third direct current voltage output to the battery management unit. Therefore, the battery management unit can operate based on the power supply of the third direct current voltage. After the power is supplied to the battery management unit, information such as a voltage, a current, and a cell temperature of a battery in the energy storage system may be detected in real time, and an operating state of the energy storage system may be further monitored to ensure battery safety and a service life of the energy storage system, so that the energy storage system can better supply power to a load, power supply efficiency of the energy storage system is improved, and applicability is stronger.

In a possible implementation, the first power conversion module includes a plurality of power conversion units, and a quantity of power conversion units is greater than a target quantity required by supply power of the energy storage system; and the first power conversion module is configured to: when a target power conversion unit in the plurality of power conversion units is faulty, convert, based on a power conversion unit other than the target power conversion unit in the plurality of power conversion units, the alternating current voltage output by the alternating current mains module or the alternating current voltage output by the energy storage converter module into the first direct current voltage. In this way, surplus power conversion units may be configured. When a single AC-to-DC converter is faulty, a function of the first power conversion module may be implemented by using another AC-to-DC converter, thereby improving reliability when the first power conversion module operates.

In a possible implementation, the energy storage system further includes a fifth power conversion module, and the energy storage module is connected to the direct current bus through the fifth power conversion module; and the fifth power conversion module is configured to convert the direct current voltage output by the energy storage module into a bus voltage required by the direct current bus, so that the energy storage module can supply power to the direct current bus.

According to a second aspect, an embodiment of this application further provides a power supply control method for a battery management system. The power supply control method is applicable to an energy storage system, the energy storage system includes a direct current bus, an energy storage module, an alternating current mains module, an energy storage converter module, a power conversion module, and a battery management system, and the battery management system includes a container monitoring unit. A first input end of the power conversion module is connected to an output end of the alternating current mains module or an output end of the energy storage converter module, a second input end of the power conversion module is connected to an output end of the direct current bus, a third input end of the power conversion module is connected to an output end of the energy storage module, a first output end of the power conversion module is connected to a first input end of the container monitoring unit, and the second input end of the power conversion module is connected to a second input end of the container monitoring unit.

The power supply control method includes: converting, by using the power conversion module, an alternating current voltage output by the alternating current mains module or an alternating current voltage output by the energy storage converter module into a first direct current voltage; using, by using the power conversion module, a maximum voltage among a direct current voltage output by the energy storage module, a bus voltage output by the direct current bus, and the first direct current voltage as a second direct current voltage; and converting the second direct current voltage into a third direct current voltage and a fourth direct current voltage by using the power conversion module, and separately supplying power to the container monitoring unit based on the third direct current voltage and the fourth direct current voltage, where the third direct current voltage is less than the fourth direct current voltage. In this way, at least one power supply device in the direct current bus, the energy storage module, the alternating current mains module, or the energy storage converter module may supply power to the container monitoring unit in the battery management system, thereby improving reliability of the energy storage system. In addition, the container monitoring unit is first charged by using the small third direct current voltage, so that a charging speed can be improved. Then, the container monitoring unit is charged by using the large fourth direct current voltage, so that charging efficiency can be improved. After the power supply, the container monitoring unit collects a system parameter of the energy storage system or performs data transmission with a system controller of the energy storage system, thereby improving stability of the energy storage system.

In a possible implementation, the power conversion module includes a first power conversion module, a second power conversion module, and a third power conversion module. Input ends of both the first power conversion module and the second power conversion module may be used as the first input end of the power conversion module, a first output end of the first power conversion module is connected to a first input end of the third power conversion module, an output end of the second power conversion module is connected to the second input end of the container monitoring unit as a second output end of the power conversion module, a first output end of the third power conversion module is used as the first output end of the power conversion module, and the first output end of the third power conversion module is connected to the first input end of the container monitoring unit.

The converting, by using the power conversion module, an alternating current voltage output by the alternating current mains module or an alternating current voltage output by the energy storage converter module into a first direct current voltage includes: converting, by using the first power conversion module, the alternating current voltage output by the alternating current mains module or the alternating current voltage output by the energy storage converter module into the first direct current voltage, and supplying power to the third power conversion module based on the first direct current voltage.

The using, by using the power conversion module, a maximum voltage among a direct current voltage output by the energy storage module, a bus voltage output by the direct current bus, and the first direct current voltage as a second direct current voltage includes: using, by using the third power conversion module, the maximum voltage among the direct current voltage output by the energy storage module, the bus voltage output by the direct current bus, and the first direct current voltage as the second direct current voltage.

The power supply control method further includes: converting, by using the second power conversion module, the alternating current voltage output by the alternating current mains module or the alternating current voltage output by the energy storage converter module into the third direct current voltage, and supplying power to the container monitoring unit based on the third direct current voltage; and converting the second direct current voltage into the fourth direct current voltage by using the third power conversion module, and supplying power to the container monitoring unit based on the fourth direct current voltage.

It may be understood that the alternating current may be converted into the third direct current voltage applicable to the container monitoring unit by using the second power conversion module, and the alternating current may be converted into the fourth direct current voltage applicable to the container monitoring unit by using the first power conversion module and the third power conversion module. In addition, input of the fourth direct current voltage is the maximum voltage among the direct current voltage output by the energy storage module, the bus voltage output by the direct current bus, and the first direct current voltage, which helps improve charging efficiency.

In a possible implementation, the power conversion module includes a first power conversion module, a second power conversion module, and a third power conversion module. An input end of the first power conversion module is used as the first input end of the power conversion module, a first output end of the first power conversion module is connected to a first input end of the third power conversion module, a second output end of the first power conversion module is connected to an input end of the second power conversion module, an output end of the second power conversion module is used as a second output end of the power conversion module, the second output end of the power conversion module is connected to the second input end of the container monitoring unit, a first output end of the third power conversion module is used as the first output end of the power conversion module, and the first output end of the power conversion module is connected to the first input end of the container monitoring unit.

The converting, by using the power conversion module, an alternating current voltage output by the alternating current mains module or an alternating current voltage output by the energy storage converter module into a first direct current voltage includes: converting, by using the first power conversion module, the alternating current voltage output by the alternating current mains module or the alternating current voltage output by the energy storage converter module into the first direct current voltage, and supplying power to the second power conversion module and the third power conversion module based on the first direct current voltage.

The using, by using the power conversion module, a maximum voltage among a direct current voltage output by the energy storage module, a bus voltage output by the direct current bus, and the first direct current voltage as a second direct current voltage includes: using, by using the third power conversion module, the maximum voltage among the direct current voltage output by the energy storage module, the bus voltage output by the direct current bus, and the first direct current voltage as the second direct current voltage.

The power supply control method further includes: converting the first direct current voltage into the third direct current voltage by using the second power conversion module, and supplying power to the container monitoring unit based on the third direct current voltage; and converting the second direct current voltage into the fourth direct current voltage by using the third power conversion module, and supplying power to the container monitoring unit based on the fourth direct current voltage.

It may be understood that the alternating current is first converted into the direct current by using the first power conversion module, then the first direct current voltage output by the first power conversion module is converted, by using the second power conversion module, into the third direct current voltage applicable to the container monitoring unit, and the first direct current voltage output by the first power conversion module is converted, by using the third power conversion module, into the fourth direct current voltage applicable to the container monitoring unit. Therefore, the container monitoring unit can operate based on the power supply of the third direct current voltage and the fourth direct current voltage respectively, thereby improving power supply efficiency.

In a possible implementation, the power conversion module further includes a fourth power conversion module. A first input end of the fourth power conversion module is used as the second input end of the power conversion module, a second input end of the fourth power conversion module is used as the third input end of the power conversion module, and an output end of the fourth power conversion module is connected to a second input end of the third power conversion module.

The using, by using the power conversion module, a maximum voltage among a direct current voltage output by the energy storage module, a bus voltage output by the direct current bus, and the first direct current voltage as a second direct current voltage includes: converting, by using the fourth power conversion module, a larger voltage in the direct current voltage output by the energy storage module and the bus voltage output by the direct current bus into a fifth direct current voltage; and using a maximum voltage in the fifth direct current voltage and the first direct current voltage as the second direct current voltage by using the third power conversion module. It may be understood that the maximum fifth direct current voltage is first selected from the direct currents provided by the energy storage module and the direct current bus, and the first direct current voltage into which the alternating current voltage output by the alternating current mains module or the alternating current voltage output by the energy storage converter module is converted is obtained. Then, the maximum direct current voltage is selected from the fifth direct current voltage and the first direct current voltage as the second direct current voltage, so that power can be supplied to the battery management system based on the second direct current voltage, and charging efficiency can be improved.

In a possible implementation, the battery management system further includes a battery control unit, the third power conversion module includes a first power conversion unit, and an input end of the first power conversion unit is used as an input end of the third power conversion module, for example, a first input end, a second input end, and the like. A first output end of the first power conversion unit is used as the first output end of the third power conversion module, and the first output end of the third power conversion module is connected to the first input end of the container monitoring unit. A second output end of the first power conversion unit is used as a second output end of the third power conversion module, and the second output end of the third power conversion module is connected to an input end of the battery control unit.

The converting the second direct current voltage into the fourth direct current voltage by using the third power conversion module, and supplying power to the container monitoring unit based on the fourth direct current voltage includes: converting the second direct current voltage into the fourth direct current voltage by using the first power conversion unit, and supplying power to the container monitoring unit based on the fourth direct current voltage.

The power supply control method further includes: converting the second direct current voltage into the third direct current voltage by using the first power conversion unit, and supplying power to the battery control unit based on the third direct current voltage. It may be understood that a same power conversion unit separately supplies power to the container monitoring unit and the battery control unit in the battery management system, which improves power supply efficiency of the battery management system and helps improve stability of the energy storage system. After the power is supplied to the battery control unit, the battery control unit can detect battery rack parameters of battery racks, and control charging and discharging of battery packs in the battery racks based on the battery rack parameters of battery racks, to balance currents and voltages of the battery racks.

In a possible implementation, the battery management system further includes a battery control unit, the third power conversion module includes a second power conversion unit and a third power conversion unit, and input ends of both the second power conversion unit and the third power conversion unit are used as an input end of the third power conversion module, for example, a first input end, a second input end, and the like. The first input end may be connected to an output end of the first power conversion module, and the second input end may be connected to the output end of the fourth power conversion module. Alternatively, the first input end may be connected to the output end of the fourth power conversion module, and the second input end may be connected to the output end of the first power conversion module. An output end of the second power conversion unit is used as the first output end of the third power conversion module, and the first output end of the third power conversion module is connected to the first input end of the container monitoring unit. An output end of the third power conversion unit is used as a second output end of the third power conversion module, and the second output end of the third power conversion module is connected to an input end of the battery control unit.

The converting the second direct current voltage into the fourth direct current voltage by using the third power conversion module, and supplying power to the container monitoring unit based on the fourth direct current voltage includes: converting the second direct current voltage into the fourth direct current voltage by using the second power conversion unit, and supplying power to the container monitoring unit based on the fourth direct current voltage.

The power supply control method further includes: converting the second direct current voltage into the third direct current voltage by using the third power conversion unit, and supplying power to the battery control unit based on the third direct current voltage. It may be understood that a separate power conversion unit is used to supply power to the container monitoring unit in the battery management system, and a separate power conversion unit is used to supply power to the battery control unit in the battery management system, which helps improve stability of the energy storage system. After the power is supplied to the battery control unit, the battery control unit can detect battery rack parameters of battery racks, and control charging and discharging of battery packs in the battery racks based on the battery rack parameters of battery racks, to balance currents and voltages of the battery racks.

In a possible implementation, the battery management system further includes a battery management unit, the third power conversion module further includes a fourth power conversion unit, and an input end of the fourth power conversion unit is used as the input end of the third power conversion module, for example, a first input end, a second input end, and the like. An output end of the fourth power conversion unit is used as a third output end of the third power conversion module, and the third output end of the third power conversion module is connected to an input end of the battery management unit.

The power supply control method may further include: converting the second direct current voltage into the third direct current voltage by using the fourth power conversion unit, and supplying power to the battery management unit based on the third direct current voltage. It may be understood that the fourth power conversion unit in the third power conversion module in the power conversion module may convert the maximum voltage provided by the energy storage module, the direct current bus, and the alternating current mains module or the energy storage converter module into the third direct current voltage output to the battery management unit. Therefore, the battery management unit can operate based on the power supply of the third direct current voltage.

In a possible implementation, the first power conversion module includes a plurality of power conversion units, and a quantity of power conversion units is greater than a target quantity required by supply power of the energy storage system; and the power supply control method further includes: when a target power conversion unit in the plurality of power conversion units is faulty, converting, by using the first power conversion module based on a power conversion unit other than the target power conversion unit in the plurality of power conversion units, the alternating current voltage output by the alternating current mains module or the alternating current voltage output by the energy storage converter module into the first direct current voltage. In this way, surplus power conversion units may be configured. When a single AC-to-DC converter is faulty, a function of the first power conversion module may be implemented by using another AC-to-DC converter, thereby improving reliability when the first power conversion module operates.

In a possible implementation, the energy storage system further includes a fifth power conversion module, and the energy storage module is connected to the direct current bus through the fifth power conversion module; and the power supply control method further includes: converting, by using the fifth power conversion module, the direct current voltage output by the energy storage module into a bus voltage required by the direct current bus, so that the energy storage module can supply power to the direct current bus.

According to a third aspect, an embodiment of this application further provides a chip system. The chip system includes a processor, a memory, and an interface circuit. The memory, the interface circuit, and the processor are interconnected through a line. The memory stores instructions, and when the instructions are executed by the processor, the method according to the second aspect is performed.

According to a fourth aspect, an embodiment of this application further provides a computer device, including a memory and a processor connected to the memory. The memory is configured to store a computer program, and the processor is configured to invoke the computer program, so that the computer device performs the method according to the second aspect.

According to a fifth aspect, an embodiment of this application further provides a computer-readable storage medium. The computer-readable storage medium stores a computer program. The computer program is suitable for being loaded and executed by a processor, so that a computer device having the processor performs the method according to the second aspect.

According to a sixth aspect, an embodiment of this application further provides a computer program product, including computer instructions. The computer instructions are stored in a computer-readable storage medium. A processor of a computer device reads the computer instructions from the computer-readable storage medium, and executes the computer instructions, so that the computer device performs the method according to the second aspect.

It should be understood that implementation and beneficial effect of the foregoing plurality of aspects of this application may refer to each other.

### BRIEF DESCRIPTION OF DRAWINGS

FIG. 1 is a diagram of an application scenario of an energy storage system according to an embodiment of this application;
FIG. 2 to FIG. 10 each are a schematic diagram of a structure of an energy storage system according to an embodiment of this application; and
FIG. 11 is a schematic flowchart of a power supply control method for a battery management system according to an embodiment of this application.

### DESCRIPTION OF EMBODIMENTS

An energy storage system provided in this application may be applicable to a microgrid, a diesel power supply area, photovoltaic power generation, wind power generation, renewable energy, or the like, or may be applied to a large-scale distributed scenario, a small- and medium-sized distributed scenario, a microgrid, a user side scenario, or the like, which is not limited herein, for example, a photovoltaic power generation scenario and a power-consuming device power supply scenario. The following uses the power-consuming device power supply scenario as an example for description. The energy storage system provided in this application is applicable to energy storage of different types of energy storage modules. The energy storage module may include a lithium-ion battery, a lead-acid battery (or referred to as a lead-acid battery), a supercapacitor (also referred to as an electrochemical capacitor), and the like. This is not limited herein. For ease of description, the following uses a battery as an example to describe the energy storage module provided in this application.

The following describes embodiments of this application with reference to accompanying drawings in embodiments of this application.

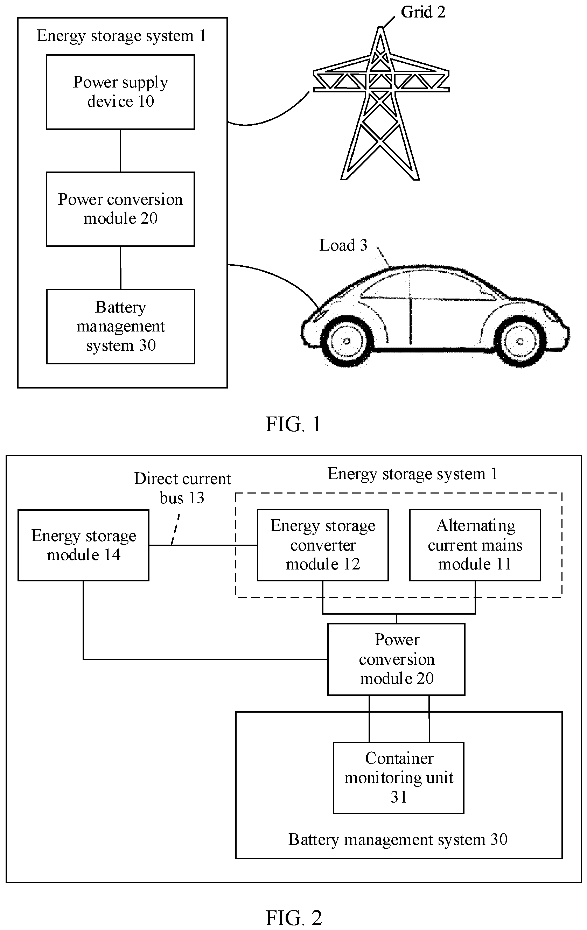

FIG. 1 is a diagram of an application scenario of an energy storage system according to an embodiment of this application. As shown in FIG. 1, an energy storage system 1 may include a power supply device 10, a power conversion module 20, and a battery management system (battery management system, BMS) 30. The power supply device 10 may be an alternating current mains module and/or an energy storage converter module that provide/provides alternating currents/an alternating current, or may be a direct current bus and an energy storage module that provide direct currents. The energy storage converter module may be a power conversion system (power conversion system, PCS), and is configured to convert a direct current into an alternating current. The direct current input to the energy storage converter module may come from the direct current output by the direct current bus.

It should be noted that the direct current output by the direct current bus may be further used to supply power to the energy storage module and the alternating current mains module may be further configured to supply power to the energy storage module. For example, the direct current bus is connected to the energy storage module through a power converter, a direct current voltage output by the direct current bus is 48 V, and a direct current voltage applicable to the energy storage module is 12 V. The power converter is configured to convert the 48 V direct current output by the direct current bus into a 12 V direct current applicable to the energy storage module. For another example, the alternating current mains module is connected to the energy storage module by using two power converters, an alternating current voltage output by the alternating current mains module is 220 V, and the direct current voltage applicable to the energy storage module is 12 V. One power converter converts the 220 V alternating current output by the alternating current mains module into a 48 V direct current, and the other power converter converts the 48 V direct current into the 12 V direct current applicable to the energy storage module.

The power conversion module 20 includes at least one power converter. The power converter may be a DC-to-DC converter (direct current-to-direct current converter), an AC-to-DC converter (alternating current-to-direct current converter), a power module with a rectification or inversion function, or the like. This is not limited herein. The AC-to-DC converter may convert the alternating currents/the alternating current output by the alternating current mains module and/or the energy storage converter module into direct currents/the direct current. The DC-to-DC converter may convert the direct currents output by the direct current bus and the energy storage module into the direct current voltage used in the battery management system 30, and may further convert the direct current output by the AC-to-DC converter into the direct current voltage used in the battery management system 30.

The battery management system 30 is used to detect operating states of batteries in the energy storage system 1, so that consistency of battery states can be maintained, and performance attenuation and safety problems of a battery string caused by battery state differences are avoided.

In the energy storage system 1 shown in FIG. 1, in a process in which the energy storage system 1 supplies power to a grid 2 or a load 3 (an electric vehicle shown in FIG. 1, and electronic devices such as an air conditioner, a mobile phone, a computer, an electric water heater, and an electric kettle may be further included), the power supply device 10 may supply power to the battery management system 30 by using the power conversion module 20. In addition, the battery management system 30 monitors information such as a voltage, a current, and a cell temperature of the battery in real time, and may further monitor an operating environment of the energy storage system 1 to ensure battery safety and a service life of the energy storage system 1, so that the energy storage system 1 can better supply power to the load or the grid.

FIG. 2 is a schematic diagram of a structure of an energy storage system according to an embodiment of this application. As shown in FIG. 2, an energy storage system 1 may include an alternating current mains module 11, an energy storage converter module 12, a direct current bus 13, an energy storage module 14, a power conversion module 20, and a battery management system 30. The battery management system 30 includes a container monitoring unit (container monitoring unit, CMU) 31. The container monitoring unit 31 may be configured to collect a system parameter of the energy storage system 1 in real time or perform data transmission (for example, receiving different scheduling instructions from the system controller of the energy storage system 1) with a system controller of the energy storage system 1, to monitor an operating state of the energy storage system 1 in real time. The system parameter herein may include a temperature and humidity of the energy storage system 1, or another parameter. After detecting that the operating state of the energy storage system 1 is abnormal, the container monitoring unit 31 may send alarm information to the system controller of the energy storage system 1, to prompt a user to maintain the energy storage system 1 in time.

The alternating current mains module 11, the energy storage converter module 12, the direct current bus 13, and the energy storage module 14 may be the power supply device 10. As shown in FIG. 2, a first input end of the power conversion module 20 is connected to an output end of the alternating current mains module 11 or the energy storage converter module 12, a second input end of the power conversion module 20 is connected to the direct current bus 13, and a third input end of the power conversion module 20 is connected to the energy storage module 14. A first output end of the power conversion module 20 is connected to a first input end of the container monitoring unit 31, and a second output end of the power conversion module 20 is connected to a second input end of the container monitoring unit 31. In this way, the power conversion module 20 can perform power conversion on direct currents respectively provided by the direct current bus 13 and the energy storage module 14, and/or on an alternating current provided by the alternating current mains module 11 or the energy storage converter module 12, and transmit the converted direct current to the container monitoring unit 31 in the battery management system 30, to supply power to the container monitoring unit 31, so that the operating state of the energy storage system 1 can be monitored in real time, which helps improve stability of the energy storage system 1.

In this embodiment of this application, the power conversion module 20 is configured to convert an alternating current voltage output by the alternating current mains module 11 or an alternating current voltage output by the energy storage converter module 12 into a first direct current voltage. The power conversion module 20 is further configured to: use, as a second direct current voltage, a maximum voltage among a direct current voltage output by the energy storage module 14, a bus voltage output by the direct current bus 13, and the first direct current voltage; and convert the second direct current voltage into a third direct current voltage and a fourth direct current voltage, and separately supply power to the container monitoring unit 31 based on the third direct current voltage and the fourth direct current voltage.

The third direct current voltage is less than the fourth direct current voltage. Values of voltages such as the first direct current voltage, the second direct current voltage, the third direct current voltage, and the fourth direct current voltage are not limited in this application. For example, the first direct current voltage is 48 V, the second direct current voltage is 48 V, the third direct current voltage is 12 V, and the fourth direct current voltage is 24 V.

It may be understood that a small voltage can improve power supply efficiency, so that the container monitoring unit 31 is first charged by using the direct current provided by the third direct current voltage, so that a power supply speed can be increased. Then, the container monitoring unit 31 is charged by using the direct current provided by the second direct current voltage, so that charging efficiency can be improved. In this way, at least one power supply device in the direct current bus 13, the energy storage module 14, the alternating current mains module 11, or the energy storage converter module 12 supplies power to the container monitoring unit 31 in the battery management system 30 through two power supply circuits of different voltage values, thereby improving the charging efficiency of the container monitoring unit 31 and improving the stability of the energy storage system 1. In addition, when the alternating current mains module 11 and the energy storage converter module 12 are powered off and cannot provide the alternating current, the direct current bus 13 and the energy storage module 14 may further supply power to the battery management system 30, thereby further improving power supply reliability. After the power supply, the container monitoring unit 31 collects the system parameter of the energy storage system 1 or perform the data transmission with the system controller of the energy storage system 1, thereby improving the stability of the energy storage system 1.

In some possible implementations, if the alternating current mains module 11, the energy storage converter module 12, the direct current bus 13, and the energy storage module 14 all operate normally, the first direct current voltage into which the alternating current provided by the alternating current mains module 11 or the energy storage converter module 12 is converted is greater than the bus voltage output by the direct current bus 13, and the bus voltage output by the direct current bus 13 is greater than the direct current voltage output by the energy storage module 14. In this way, when there is the alternating current, the alternating current mains module 11 or the energy storage converter module 12 may be preferably used to supply power to the battery management system 30. When there is no alternating current, the direct current bus 13 can first be used to supply power to the battery management system 30. When there is no direct current bus 13, the energy storage module 14 is used to supply power to the battery management system 30. No uninterruptible power supply (uninterruptible power supply, UPS) is used in the foregoing power supply strategy, which can reduce costs of the energy storage system.

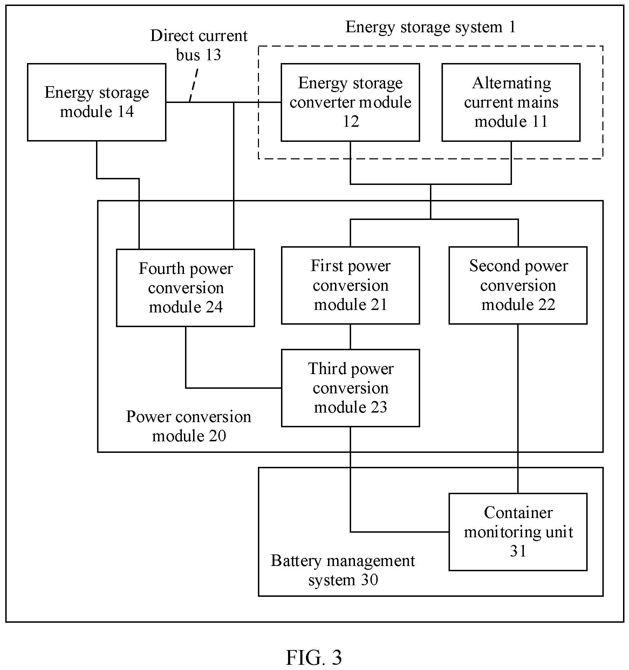

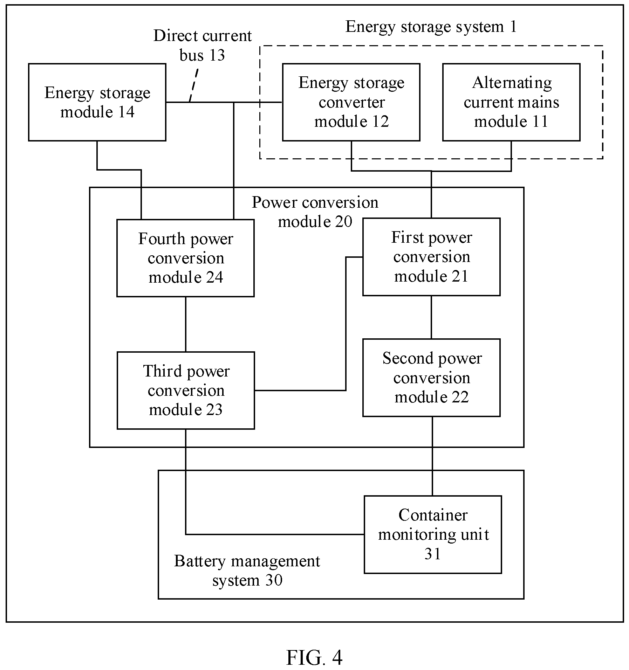

For a structure of the power conversion module 20, refer to FIG. 3 and FIG. 4. FIG. 3 and FIG. 4 are respectively schematic diagrams of structures of another energy storage system according to an embodiment of this application. For power supply devices in FIG. 3 and FIG. 4 and the container monitoring unit 31 in the battery management system 30, refer to the foregoing or the following description. Details are not described herein again.

As shown in FIG. 3, the power conversion module 20 includes a first power conversion module 21, a second power conversion module 22, a third power conversion module 23, and a fourth power conversion module 24. Input ends of both the first power conversion module 21 and the second power conversion module 22 may be used as the first input end of the power conversion module 20, and are connected to the output end of the alternating current mains module 11 or the energy storage converter module 12. An output end of the first power conversion module 21 is connected to a first input end of the third power conversion module 23, an output end of the second power conversion module 22 is used as the second output end of the power conversion module 20 and is connected to the second input end of the container monitoring unit 31. A first output end of the third power conversion module 23 is used as the second output end of the power conversion module 20 and is connected to the first input end of the container monitoring unit 31. In other words, the first power conversion module 21 is connected to the container monitoring unit 31 through the second power conversion module 22 and the third power conversion module 23.

In some possible implementations, the first power conversion module 21 is configured to: convert the alternating current voltage output by the alternating current mains module 11 or the alternating current voltage output by the energy storage converter module 12 into the first direct current voltage, and supply power to the third power conversion module 23 based on the first direct current voltage. The second power conversion module 22 is configured to: convert the alternating current voltage output by the alternating current mains module 11 or the alternating current voltage output by the energy storage converter module 12 into the third direct current voltage, and supply power to the container monitoring unit 31 based on the third direct current voltage. In this way, the alternating current output by the alternating current mains module 11 or the energy storage converter module 12 may be provided for the container monitoring unit 31 by using the second power conversion module 22.

The third power conversion module 23 is configured to: use, as the second direct current voltage, the maximum voltage among the direct current voltage output by the energy storage module 14, the bus voltage output by the direct current bus 13, and the first direct current voltage, convert the second direct current voltage into the fourth direct current voltage, and supply power to the container monitoring unit 31 based on the fourth direct current voltage. In this way, the alternating current may be converted into the third direct current voltage applicable to the container monitoring unit 31 by using the second power conversion module 22, and the alternating current may be converted into the fourth direct current voltage applicable to the container monitoring unit 31 by using the first power conversion module 21 and the third power conversion module 23. In addition, input of the fourth direct current voltage is the maximum voltage among the direct current voltage output by the energy storage module 14, the bus voltage output by the direct current bus 13, and the first direct current voltage, which helps improve the charging efficiency.

As shown in FIG. 4, the power conversion module 20 includes a first power conversion module 21, a second power conversion module 22, and a third power conversion module 23. An input end of both the first power conversion module 21 is used as the first input end of the power conversion module 20 and is connected to the output end of the alternating current mains module 11 or the energy storage converter module 12. A first output end of the first power conversion module 21 is connected to a first input end of the third power conversion module 23, and a second output end of the first power conversion module 21 is connected to an input end of the second power conversion module 22. An output end of the second power conversion module 22 is used as the second output end of the power conversion module 20 and is connected to the second input end of the container monitoring unit 31. A first output end of the third power conversion module 23 is used as the first output end of the power conversion module 20 and is connected to the first input end of the container monitoring unit 31. In other words, the power supply device is connected to the container monitoring unit 31 through the first power conversion module 21 and the second power conversion module 22, and the power supply device is further connected to the container monitoring unit 31 through the first power conversion module 21 and the third power conversion module 23.

In some possible implementations, the first power conversion module 21 is configured to: convert the alternating current voltage output by the alternating current mains module 11 or the alternating current voltage output by the energy storage converter module 12 into the first direct current voltage, and supply power to the second power conversion module 22 and the third power conversion module 23 based on the first direct current voltage. The second power conversion module 22 is configured to: convert the first direct current voltage into the third direct current voltage, and supply power to the container monitoring unit 31 based on the third direct current voltage. The third power conversion module 23 is configured to: use, as the second direct current voltage, the maximum voltage among the direct current voltage output by the energy storage module 14, the bus voltage output by the direct current bus 13, and the first direct current voltage, convert the second direct current voltage into the fourth direct current voltage, and supply power to the container monitoring unit 31 based on the fourth direct current voltage. In this way, the alternating current may be first converted into the direct current by using the first power conversion module 21, then the first direct current voltage output by the first power conversion module 21 is converted, by using the second power conversion module 22, into the third direct current voltage applicable to the container monitoring unit 31, and the first direct current voltage output by the first power conversion module 21 is converted, by using the third power conversion module 23, into the fourth direct current voltage applicable to the container monitoring unit 31. Therefore, the container monitoring unit 31 can operate based on the power supply of the third direct current voltage and the fourth direct current voltage respectively, thereby improving power supply efficiency.

As shown in FIG. 3 and FIG. 4, a first input end of the fourth power conversion module 24 is used as the second input end of the power conversion module 20 and is connected to an output end of the direct current bus 13. A second input end of the fourth power conversion module 24 is used as the third input end of the power conversion module 20 and is connected to an output end of the energy storage module 14. An output end of the fourth power conversion module 24 is connected to a second input end of the third power conversion module 23. In other words, the first power conversion module 21 and the fourth power conversion module 24 are connected to the container monitoring unit 31 (or the battery management system 30 or another component thereof, for example, a battery management unit or a battery control unit) through the third power conversion module 23.

In some possible implementations, the fourth power conversion module 24 is configured to convert a larger voltage in the direct current voltage output by the energy storage module 14 and the bus voltage output by the direct current bus 13 into a fifth direct current voltage. The third power conversion module 23 is configured to use a maximum voltage in the fifth direct current voltage and the first direct current voltage as the second direct current voltage. In this way, the maximum fifth direct current voltage may be first selected from the direct currents provided by the energy storage module 14 and the direct current bus 13, and the first direct current voltage into which the alternating current voltage output by the alternating current mains module 11 or the alternating current voltage output by the energy storage converter module 12 is converted is obtained. Then, the maximum direct current voltage is selected from the fifth direct current voltage and the first direct current voltage as the second direct current voltage, so that power can be supplied to the battery management system 30 based on the second direct current voltage, and charging efficiency can be improved.

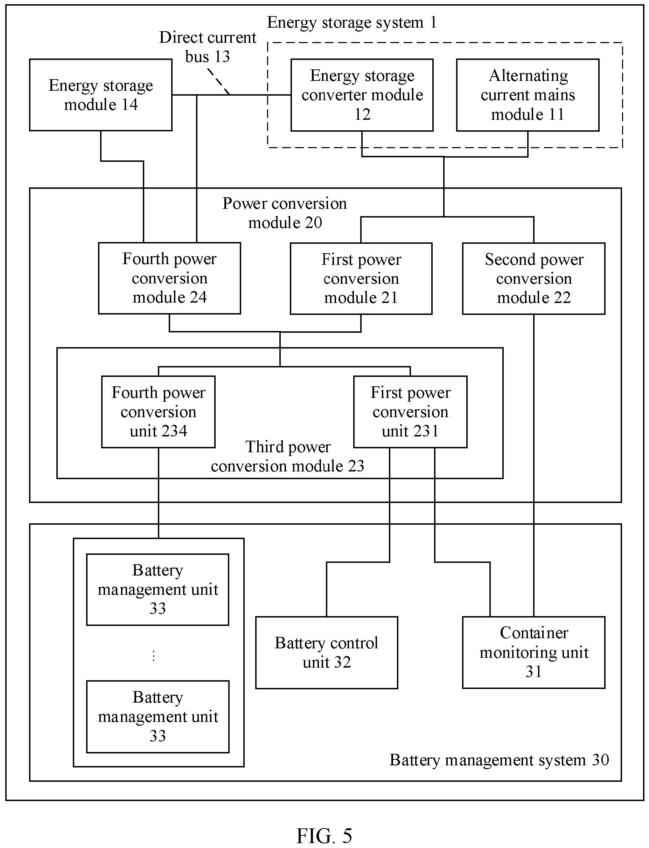

For structures of the third power conversion module and the battery management system, refer to FIG. 5, FIG. 6, and FIG. 7. FIG. 5, FIG. 6, and FIG. 7 are respectively schematic diagrams of structures of another energy storage system according to an embodiment of this application. For power supply devices 10 in FIG. 5, FIG. 6, and FIG. 7 and power conversion modules in the power conversion module 20, refer to the foregoing or the following description. Details are not described herein again.

As shown in FIG. 5, FIG. 6, and FIG. 7, the battery management system 30 further includes a battery control unit (battery control unit, BCU) 32, and when the energy storage system 1 includes a plurality of battery racks (each battery rack may include a plurality of battery strings in series), the battery control unit 32 may be configured to detect battery rack parameters of the battery racks, and control charging or discharging of battery packs in the battery racks based on the battery rack parameters of the battery racks, to balance currents and voltages of the battery racks. The battery rack parameter herein may include a state of charge (state of charge, SOC) value, a state of energy (state of energy, SOE) value, a state of health (state of health, SOH) value, a state of function/power (state of function/power, SOF/SOP) value, a state of safety (state of safety, SOS) value, a maximum operating current, and the like. This is not limited herein. SOC may be understood as a percentage of remaining battery power, and ranges from 0% to 100%. SOE may be understood as remaining energy of the battery, which is remaining mileage for an entire vehicle. SOH may be understood as a percentage of current battery capacity to factory capacity, which indicates a battery aging degree. SOF/SOP is used to evaluate a state of a power parameter of the battery. SOS is used to evaluate a failure or another state of safety of the battery.

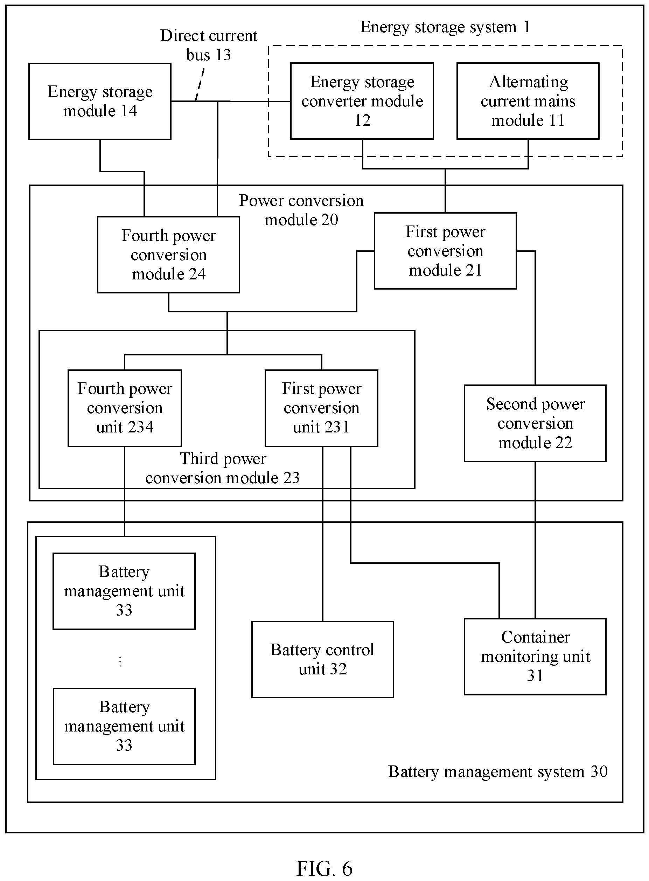

As shown in FIG. 5 and FIG. 6, the third power conversion module 23 includes a first power conversion unit 231. An input end of the first power conversion unit 231 is used as an input end of the third power conversion module 23, for example, a first input end, a second input end, and the like. The first input end may be connected to the output end of the first power conversion module 21, and the second input end may be connected to the output end of the fourth power conversion module 24. Alternatively, the first input end may be connected to the output end of the fourth power conversion module 24, and the second input end may be connected to the output end of the first power conversion module 21. In other words, the third power conversion module 23 may be connected to the first power conversion module 21 through the first power conversion unit 231, or may be connected to the fourth power conversion module 24 through the first power conversion unit 231. A first output end of the first power conversion unit 231 is used as a second output end of the third power conversion module 23 and is connected to an input end of the battery control unit 32. A second output end of the first power conversion unit 231 is used as the first output end of the third power conversion module 23, that is, the first output end of the power conversion module 20, and is connected to the first input end of the container monitoring unit 31. In other words, the first power conversion module 21 and the fourth power conversion module 24 may be connected to the container monitoring unit 31 through the first power conversion unit 231, or may be connected to the battery control unit 32 through the first power conversion unit 231.

In some possible implementations, the first power conversion unit 231 is configured to: convert the second direct current voltage into the fourth direct current voltage, and supply power to the container monitoring unit 31 based on the fourth direct current voltage. The first power conversion unit 231 is further configured to: convert the second direct current voltage into the third direct current voltage, and supply power to the battery control unit 32 based on the first direct current voltage. In this way, a same power conversion unit separately supplies power to the container monitoring unit 31 and the battery control unit 32 in the battery management system 30, which improves power supply efficiency of the battery management system 30 and helps improve stability of the energy storage system 1. After the power is supplied to the battery control unit 32, the battery control unit 32 can detect the battery rack parameters of the battery racks, and control the charging and the discharging of the battery packs in the battery racks based on the battery rack parameters of the battery racks, to balance the currents and the voltages of the battery racks.

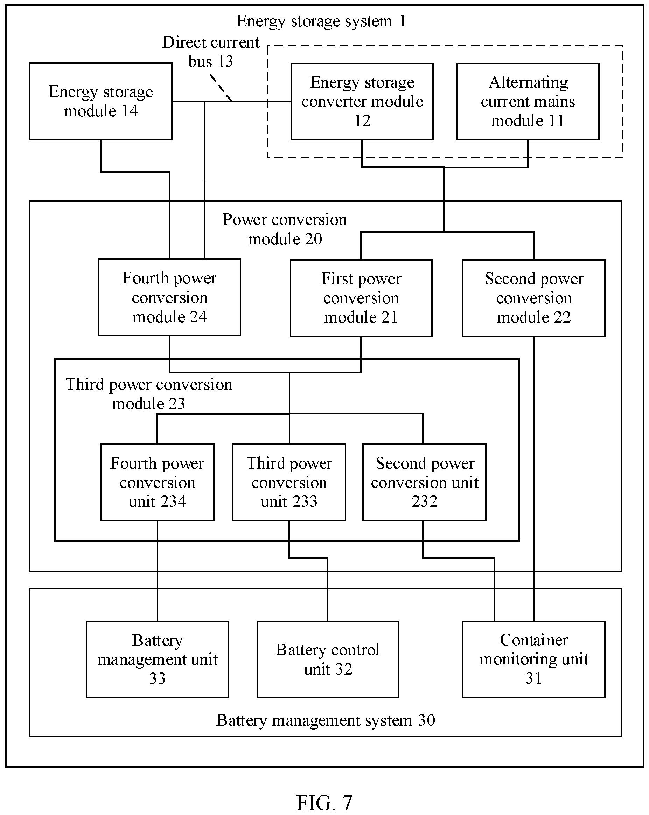

As shown in FIG. 7, the third power conversion module 23 includes a second power conversion unit 232 and a third power conversion unit 233. Input ends of both the second power conversion unit 232 and the third power conversion unit 233 are used as the input end of the third power conversion module 23, for example, a first input end, a second input end, and the like. An output end of the second power conversion unit 232 is used as the first output end of the third power conversion module 23, that is, the first output end of the power conversion module 20, and is connected to the first input end of the container monitoring unit 31. A first output end of the third power conversion unit 233 is used as the second output end of the third power conversion module 23, is further used as a third output end of the power conversion module 20, and is connected to the input end of the battery control unit 32. In other words, the first power conversion module 21 and the fourth power conversion module 24 are connected to the container monitoring unit 31 through the second power conversion unit 232, and the first power conversion module 21 and the fourth power conversion module 24 are connected to the battery control unit 32 through the third power conversion unit 233.

In some possible implementations, the second power conversion unit 232 is configured to: convert the second direct current voltage into the fourth direct current voltage, and supply power to the container monitoring unit 31 based on the fourth direct current voltage. The third power conversion unit 233 is configured to: convert the second direct current voltage into the third direct current voltage, and supply power to the battery control unit 32 based on the third direct current voltage. In this way, a separate power conversion unit is used to supply power to the container monitoring unit 31 in the battery management system 30, and a separate power conversion unit is used to supply power to the battery control unit 32 in the battery management system 30, which helps improve the stability of the energy storage system 1. After the power is supplied to the battery control unit 32, the battery control unit 32 can detect the battery rack parameters of the battery racks, and control the charging and the discharging of the battery packs in the battery racks based on the battery rack parameters of the battery racks, to balance the currents and the voltages of the battery racks.

As shown in FIG. 5, FIG. 6, and FIG. 7, the battery management system 30 further includes a plurality of battery management units (battery management unit, BMU) 33. The battery management unit 33 is configured to detect information such as a voltage, a current, and a cell temperature of the battery in the energy storage system 1 in real time, and may further monitor an operating state of the energy storage system 1 to ensure battery safety and a service life of the energy storage system, so that the energy storage system 1 can better supply power to a load, power supply efficiency of the energy storage system 1 is improved, and applicability is stronger.

As shown in FIG. 5, FIG. 6, and FIG. 7, the third power conversion module 23 further includes a fourth power conversion unit 234. An input end of the fourth power conversion unit 234 is used as the input end of the third power conversion module 23, for example, a first input end, a second input end, and the like. A second input end of the fourth power conversion unit 234 is connected to the fourth power conversion module 24. An output end of the fourth power conversion unit 234 is used as a third output end of the third power conversion module 23 and is connected to the battery management unit 33. In other words, the first power conversion module 21 and the fourth power conversion module 24 may further supply power to the battery management unit 33 through the fourth power conversion unit 234.

In some possible implementations, the fourth power conversion unit 234 is configured to convert the second direct current voltage into the third direct current voltage to supply power to the battery management unit 33. In this way, the fourth power conversion unit 234 in the third power conversion module 23 in the power conversion module 20 may convert a maximum voltage provided by the energy storage module 14, the direct current bus 13, and the alternating current mains module 11 or the energy storage converter module 12 into the third direct current voltage output to the battery management unit 33. Therefore, the battery management unit 33 can operate based on the power supply of the third direct current voltage. After the power is supplied to the battery management unit 33, the information such as the voltage, the current, and the cell temperature of the battery in the energy storage system 1 may be detected in real time, and the operating state of the energy storage system 1 may be further monitored to ensure the battery safety and the service life of the energy storage system, so that the energy storage system 1 can better supply power to the load, the power supply efficiency of the energy storage system 1 is improved, and the applicability is stronger.

It should be noted that the first power conversion unit 231 and the third power conversion unit 233 may further convert the second direct current voltage into a direct current voltage different from the third direct current voltage, and the direct current voltage is supplied to the battery management unit 33 alone or together with the third direct current voltage. The fourth power conversion unit 234 may further convert the second direct current voltage into a direct current voltage different from the third direct current voltage, and the direct current voltage is supplied to the battery management unit 33 alone or together with the first direct current voltage.

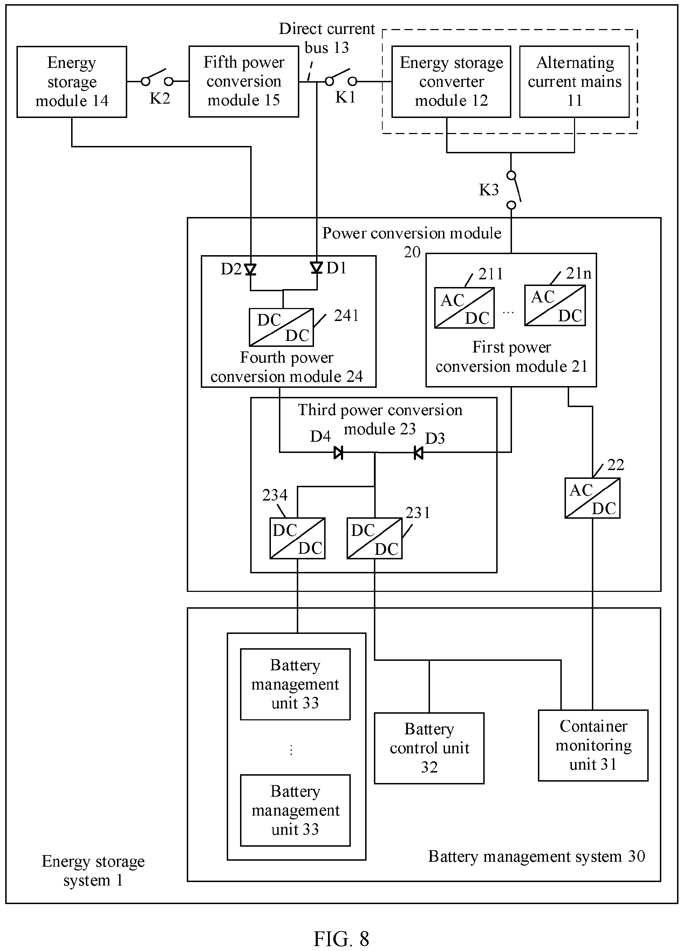

For specific structures of the first power conversion module 21, the second power conversion module 22, the third power conversion module 23, and the fourth power conversion module 24, refer to FIG. 8, FIG. 9, and FIG. 10. FIG. 8, FIG. 9, and FIG. 10 are respectively schematic diagrams of structures of another energy storage system according to this application. As shown in FIG. 8, FIG. 9, and FIG. 10, the first power conversion module 21 may include a plurality of power conversion units, for example, n power conversion units such as an AC-to-DC converter 211, ..., and an AC-to-DC converter 21n. n is greater than a target quantity required by supply power of the energy storage system 1, so that surplus power conversion units may be configured.

In some possible implementations, the first power conversion module 21 is configured to: when a target power conversion unit in the plurality of power conversion units is faulty, convert, based on a power conversion unit other than the target power conversion unit in the plurality of power conversion units, the alternating current voltage output by the alternating current mains module 11 or the alternating current voltage output by the energy storage converter module 12 into the first direct current voltage. In this way, when a single AC-to-DC converter is faulty, a function of the first power conversion module 21 may be implemented by using another AC-to-DC converter, thereby improving reliability when the first power conversion module 21 operates.

In FIG. 8, FIG. 9, and FIG. 10, an example in which the AC-to-DC converter is used as the second power conversion module 22 is used for description. Actually, the second power conversion module 22 may also include one or more functional modules with an AC-to-DC conversion function (that is, an inversion function). An AC-to-DC converter 22 in FIG. 8 is connected to the alternating current mains module 11 or the energy storage converter module 12 through the first power conversion module 21 and a third switch K3. The AC-to-DC converter 22 is configured to: when the third switch K3 is switched on, convert the first direct current voltage output by the first power conversion module 21 into the third direct current voltage, and supply power to the container monitoring unit 31 based on the third direct current voltage.

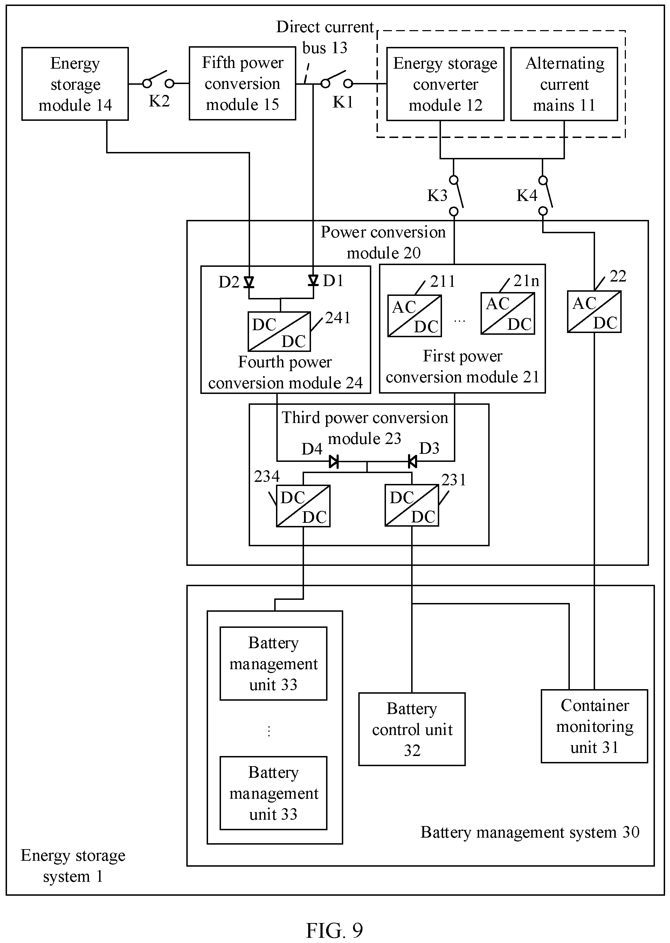

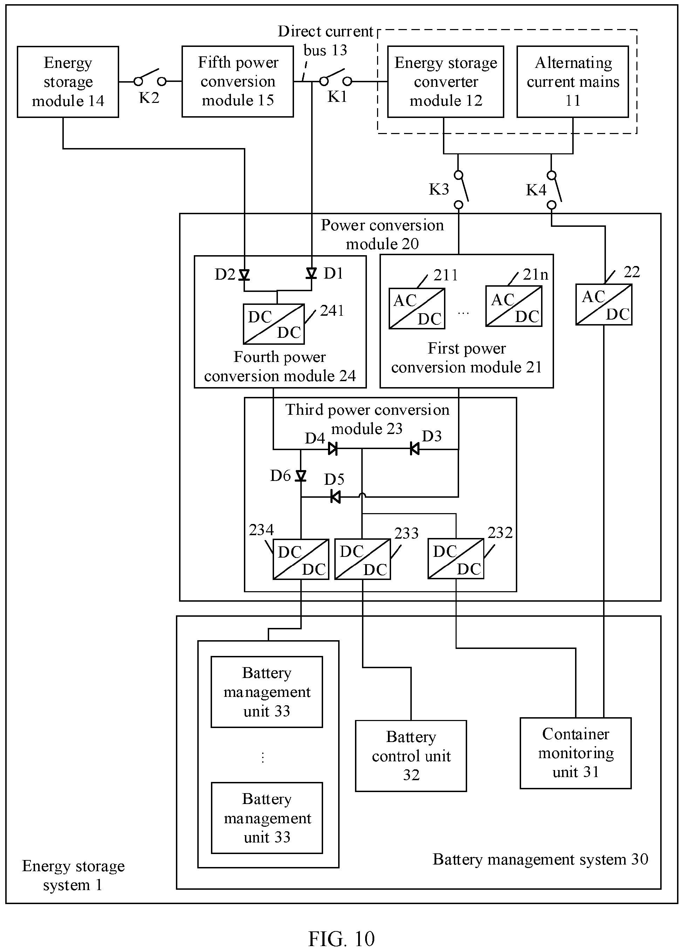

The AC-to-DC converter 22 in FIG. 9 and FIG. 10 is connected to the alternating current mains module 11 or the energy storage converter module 12 through the third switch K3, and may further be connected to the alternating current mains module 11 or the energy storage converter module 12 through a fourth switch K4. The AC-to-DC converter 22 in FIG. 9 and FIG. 10 may be configured to: when the fourth switch K4 is switched on, convert the alternating current voltage output by the alternating current mains module 11 or the alternating current voltage output by the energy storage converter module 12 into the third direct current voltage, and supply power to the container monitoring unit 31 based on the third direct current voltage. It should be noted that the third switch K3 and the fourth switch K4 may be a same switch or different switches.

As shown in FIG. 8 and FIG. 9, the third power conversion module 23 may include a third diode D3, a fourth diode D4, a DC-to-DC converter 231, and a DC-to-DC converter 234. An anode of the third diode D3, used as the first input end of the third power conversion module 23, is connected to the output end of the first power conversion module 21, a cathode of the third diode D3 and a cathode of the fourth diode D4 are connected to input ends of the DC-to-DC converter 231 and the DC-to-DC converter 234, and an anode of the fourth diode D4, used as the second input end of the third power conversion module 23, is connected to the output end of the fourth power conversion module 24. An output end of the DC-to-DC converter 231 is used as the first output end of the third power conversion module 23 and is connected to the battery control unit 32. An output end of the DC-to-DC converter 234 is used as the third output end of the third power conversion module 23 and is connected to the battery management unit 33. In this way, the third power conversion module 23 may select, as the third direct current voltage, a larger voltage between the fourth direct current voltage output by the fourth power conversion module 24 and the third direct current voltage output by the first power conversion module 21, and then switch on a diode corresponding to the third direct current voltage.

For example, if the large third direct current voltage is the fourth direct current voltage output by the fourth power conversion module 24, the fourth diode D4 is switched on, and the third diode D3 is switched off. If the large third direct current voltage is the third direct current voltage output by the first power conversion module 21, the third diode D3 is switched on, and the fourth diode D4 is switched off. Then, the third direct current voltage is converted into the first direct current voltage by using the DC-to-DC converter 231, and power is supplied to the battery control unit 32. The third direct current voltage is converted into the second direct current voltage by using the DC-to-DC converter 231, and power is supplied to the container monitoring unit 31. The third direct current voltage is converted into the first direct current voltage by using the DC-to-DC converter 234, and power is supplied to the battery management unit 33.

As shown in FIG. 10, the third power conversion module 23 may include the third diode D3, the fourth diode D4, a fifth diode D5, a sixth diode D6, a DC-to-DC converter 232, a DC-to-DC converter 233, and the DC-to-DC converter 234. The anode of the third diode D3 and an anode of the fifth diode D5, used as the first input end of the third power conversion module 23, are connected to the output end of the first power conversion module 21, the anode of the fourth diode D4 and the sixth diode D6, used as the second input end of the third power conversion module 23, are connected to the output end of the fourth power conversion module 24. The cathode of the third diode D3 and the cathode of the fourth diode D4 are connected to input ends of the DC-to-DC converter 232 and the DC-to-DC converter 233, and an output end of the DC-to-DC converter 232 is used as the first output end of the third power conversion module 23 and is connected to the container monitoring unit 31. The input end of the DC-to-DC converter 233 is used as the second output end of the third power conversion module 23 and is connected to the battery control unit 32. A cathode of the fifth diode D5 and a cathode of the sixth diode D6 are connected to the input end of the DC-to-DC converter 234, and are used as the third output end of the third power conversion module 23. The output end of the DC-to-DC converter 234 is connected to the battery management unit 33. In this way, the third power conversion module 23 may select, as the third direct current voltage, the larger voltage between the fourth direct current voltage output by the fourth power conversion module 24 and the third direct current voltage output by the first power conversion module 21, and then switch on the diode corresponding to the third direct current voltage.

For example, if the large third direct current voltage is the fourth direct current voltage output by the fourth power conversion module 24, the fourth diode D4 and the sixth diode D6 are switched on, and the third diode D3 and the fifth diode D5 are switched off. If the large third direct current voltage is the third direct current voltage output by the first power conversion module 21, the third diode D3 and the fifth diode D5 are switched on, the fourth diode D4 and the sixth diode D6 are switched off. Then, the third direct current voltage is converted into the second direct current voltage by using the DC-to-DC converter 232, and the power is supplied to the container monitoring unit 31. Then, the third direct current voltage is converted into the first direct current voltage by using the DC-to-DC converter 233, and the power is supplied to the battery control unit 32. The third direct current voltage is converted into the first direct current voltage by using the DC-to-DC converter 234, and the power is supplied to the battery management unit 33.

As shown in FIG. 8, FIG. 9, and FIG. 10, the fourth power conversion module 24 may include a first diode D1, a second diode D2, and a DC-to-DC converter 241. In addition, an anode of the first diode D1, used as the first input end of the fourth power conversion module 24, is connected to the output end of the direct current bus 13, and an anode of the second diode D2, used as the second input end of the fourth power conversion module 24, is connected to the output end of the energy storage module 14. A cathode of the first diode D1 and a cathode of the second diode D2 are connected to an input end of the DC-to-DC converter 241, and an output end of the DC-to-DC converter 241 is used as the output end of the fourth power conversion module 24. In this way, the fourth power conversion module 24 may select, as the fourth direct current voltage, the larger voltage between the direct current voltage output by the energy storage module 14 and the bus voltage output by the direct current bus 13, and then switch on a diode corresponding to the fourth direct current voltage. For example, if the fourth direct current voltage is the current voltage output by the energy storage module 14, the second diode D2 is switched on, and the first diode D1 is switched off. If the fourth direct current voltage is the bus voltage output by the direct current bus 13, the first diode D1 is switched on, and the second diode D2 is switched off. Then, the DC-to-DC converter 241 may supply power to the third power conversion module 23 based on the fourth direct current voltage.

In some possible implementations, the energy storage system 1 further includes a fifth power conversion module 15. The fifth power conversion module may be a DC-to-DC converter. The energy storage module 14 is connected to the direct current bus 13 through the fifth power conversion module 15. As shown in FIG. 8, FIG. 9, and FIG. 10, the energy storage module 14 is connected to the fifth power conversion module 15 through a second switch K2, and the fifth power conversion module 15 may be connected to an input end of the energy storage converter module 12 through the direct current bus 13 and a first switch K1. The fifth power conversion module 15 is configured to convert the direct current voltage output by the energy storage module 14 into a bus voltage required by the direct current bus 13.

In a process of supplying power to the battery management system 30 normally, the energy storage module 14, the alternating current mains module 11, or the energy storage converter module 12 all operate normally, and the first switch K1, the second switch K2, the third switch K3, and the fourth switch K4 are all switched on. The first switch K1 is automatically switched off when the energy storage module 14 is faulty, the second switch K2 is automatically switched off when the fifth power conversion module 15 is faulty, and when the alternating current mains module 11 or the energy storage converter module 12 is faulty or a power outage occurs, the third switch K3 and the fourth switch K4 are automatically switched off, to protect the energy storage system.

It should be noted that the DC-to-DC converter and the AC-to-DC converter shown in FIG. 8, FIG. 9, and FIG. 10 are examples. Actually, the DC-to-DC converter may be one or more functional modules that have a DC-to-DC conversion function (that is, a rectification function), a direct current voltage boost function, or a direct current voltage buck function. The AC-to-DC converter may be one or more functional modules that have an AC-to-DC conversion function (that is, an inversion function).

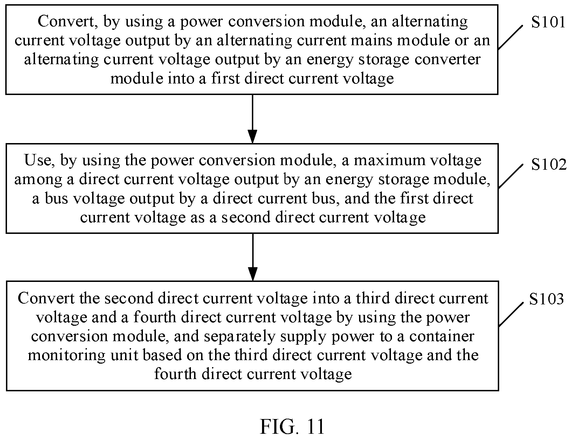

FIG. 11 shows a power supply control method for a battery management system according to an embodiment of this application. The power supply control method may be applicable to an energy storage system, the energy storage system includes a direct current bus, an energy storage module, an alternating current mains module, an energy storage converter module, a power conversion module, and a battery management system, and the battery management system includes a container monitoring unit. A first input end of the power conversion module is connected to an output end of the alternating current mains module or an output end of the energy storage converter module, a second input end of the power conversion module is connected to an output end of the direct current bus, and a third input end of the power conversion module is connected to an output end of the energy storage module. A first output end of the power conversion module is connected to a first input end of the container monitoring unit, and a second input end of the power conversion module is connected to a second input end of the container monitoring unit. For a description of the energy storage system, refer to the energy storage system described in FIG. 2 to FIG. 10. Details are not described herein again. The power supply control method includes but is not limited to the following steps S101 to S103.

S101: Convert, by using the power conversion module, an alternating current voltage output by the alternating current mains module or an alternating current voltage output by the energy storage converter module into a first direct current voltage.

In a possible implementation, step S101 may be performed by a first power conversion module included in the power conversion module, and an input end of the first power conversion module may be used as the first input end of the power conversion module. Therefore, the first power conversion module may convert the alternating current voltage output by the alternating current mains module or the alternating current voltage output by the energy storage converter module into the first direct current voltage.

In a possible implementation, the first power conversion module includes a plurality of power conversion units, and a quantity of power conversion units is greater than a target quantity required by supply power of the energy storage system; and the power supply control method further includes: when a target power conversion unit in the plurality of power conversion units is faulty, converting, by using the first power conversion module based on a power conversion unit other than the target power conversion unit in the plurality of power conversion units, the alternating current voltage output by the alternating current mains module or the alternating current voltage output by the energy storage converter module into the first direct current voltage. In this way, surplus power conversion units may be configured. When a single AC-to-DC converter is faulty, a function of the first power conversion module may be implemented by using another AC-to-DC converter, thereby improving reliability when the first power conversion module operates.

S102: Use, by using the power conversion module, a maximum voltage among a direct current voltage output by the energy storage module, a bus voltage output by the direct current bus, and the first direct current voltage as a second direct current voltage.

In a possible implementation, the power conversion module further includes a third power conversion module. A first input end of the third power conversion module is connected to a first output end of the first power conversion module, and step S101 may further include: supplying power to the third power conversion module by using the first power conversion module based on the first direct current voltage. Step S102 may include: using, by using the third power conversion module, the maximum voltage among the direct current voltage output by the energy storage module, the bus voltage output by the direct current bus, and the first direct current voltage as the second direct current voltage. A first output end of the third power conversion unit is used as the first output end of the power conversion module, and the first output end of the power conversion module is connected to the first input end of the container monitoring unit. In this way, the third power conversion module may select a maximum voltage provided by the direct current bus, the energy storage module, and the alternating current mains module or the energy storage converter module, convert the maximum voltage, and output the maximum voltage to the container monitoring unit.

In a possible implementation, the power conversion module further includes a fourth power conversion module. A first input end of the fourth power conversion module is used as the second input end of the power conversion module, and the second input end of the power conversion module is connected to the output end of the direct current bus. A second input end of the fourth power conversion module is used as the third input end of the power conversion module, and the third input end of the power conversion module is connected to the output end of the energy storage module. An output end of the fourth power conversion module is connected to a second input end of the third power conversion module.

Step S102 may include: converting, by using the fourth power conversion module, a larger voltage in the direct current voltage output by the energy storage module and the bus voltage output by the direct current bus into a fifth direct current voltage; and using a maximum voltage in the fifth direct current voltage and the first direct current voltage as the second direct current voltage by using the third power conversion module.

It may be understood that the maximum fifth direct current voltage is first selected from the direct currents provided by the energy storage module and the direct current bus, and the first direct current voltage into which the alternating current voltage output by the alternating current mains module or the alternating current voltage output by the energy storage converter module is converted is obtained. Then, the maximum direct current voltage is selected from the fifth direct current voltage and the first direct current voltage as the second direct current voltage, so that power can be supplied to the battery management system based on the second direct current voltage, and charging efficiency can be improved.

S103: Convert the second direct current voltage into a third direct current voltage and a fourth direct current voltage by using the power conversion module, and separately supply power to the container monitoring unit based on the third direct current voltage and the fourth direct current voltage.

The third direct current voltage is less than the fourth direct current voltage.

In the method described in FIG. 11, by using the power conversion module, the alternating current voltage output by the alternating current mains module or the alternating current voltage output by the energy storage converter module is first converted into the first direct current voltage. Then, by using the power conversion module, the maximum voltage among the direct current voltage output by the energy storage module, the bus voltage output by the direct current bus, and the first direct current voltage is used as the second direct current voltage. Then, the second direct current voltage is converted into the third direct current voltage and the fourth direct current voltage by using the power conversion module, and the power is separately supplied to the container monitoring unit based on the third direct current voltage and the fourth direct current voltage. In this way, at least one power supply device in the direct current bus, the energy storage module, the alternating current mains module, or the energy storage converter module may supply power to the container monitoring unit in the battery management system, thereby improving reliability of the energy storage system. In addition, the container monitoring unit is first charged by using the small third direct current voltage, so that a power supply speed can be improved. Then, the container monitoring unit is charged by using the large fourth direct current voltage, so that charging efficiency can be improved. After the power supply, the container monitoring unit collects a system parameter of the energy storage system or performs data transmission with a system controller of the energy storage system, thereby improving stability of the energy storage system.

In a possible implementation, the power conversion module further includes a second power conversion module and the third power conversion module. An output end of the first power conversion module is connected to the first input end of the third power conversion module, and step S101 may further include supplying power to the third power conversion module by using the first power conversion module based on the first direct current voltage. An input end of the second power conversion module may also be used as the first input end of the power conversion module, an output end of the second power conversion module is used as a second output end of the power conversion module, the second output end of the power conversion module is connected the second input end of the container monitoring unit, the first output end of the third power conversion module is used as the first output end of the power conversion module, and the first output end of the power conversion module is connected to the first input end of the container monitoring unit.

The power supply control method may further include: converting, by using the second power conversion module, the alternating current voltage output by the alternating current mains module or the alternating current voltage output by the energy storage converter module into the third direct current voltage, and supplying power to the container monitoring unit based on the third direct current voltage; and converting the second direct current voltage into the fourth direct current voltage by using the third power conversion module, and supplying power to the container monitoring unit based on the fourth direct current voltage.

It may be understood that the alternating current may be converted into the third direct current voltage applicable to the container monitoring unit by using the second power conversion module, and the alternating current may be converted into the fourth direct current voltage applicable to the container monitoring unit by using the first power conversion module and the third power conversion module. In addition, input of the fourth direct current voltage is the maximum voltage among the direct current voltage output by the energy storage module, the bus voltage output by the direct current bus, and the first direct current voltage, which helps improve the charging efficiency.

In another possible implementation, the power conversion module further includes the second power conversion module and the third power conversion module. The first output end of the first power conversion module is connected to the first input end of the third power conversion module, and the second output end of the first power conversion module is connected to the input end of the second power conversion module. Step S101 may further include supplying power to the second power conversion module and the third power conversion module by using the first power conversion module based on the first direct current voltage. The output end of the second power conversion unit is used as the second output end of the power conversion module, and the second output end of the power conversion module is connected to the second input end of the container monitoring unit. The first output end of the third power conversion unit is used as the first output end of the power conversion module, and the first output end of the power conversion module is connected to the first input end of the container monitoring unit.

The power supply control method may further include: converting the first direct current voltage into the third direct current voltage by using the second power conversion module, and supplying power to the container monitoring unit based on the third direct current voltage; and converting the second direct current voltage into the fourth direct current voltage by using the third power conversion module, and supplying power to the container monitoring unit based on the fourth direct current voltage.

It may be understood that the alternating current is first converted into the direct current by using the first power conversion module, then the first direct current voltage output by the first power conversion module is converted, by using the second power conversion module, into the third direct current voltage applicable to the container monitoring unit, and the first direct current voltage output by the first power conversion module is converted, by using the third power conversion module, into the fourth direct current voltage applicable to the container monitoring unit. Therefore, the container monitoring unit can operate based on the power supply of the third direct current voltage and the fourth direct current voltage respectively, thereby improving the power supply efficiency.

In a possible implementation, the battery management system further includes a battery control unit, and the third power conversion module includes a first power conversion unit. An input end of the first power conversion unit is used as an input end of the third power conversion module, for example, a first input end, a second input end, and the like. The first input end may be connected to the output end of the first power conversion module, and the second input end may be connected to the output end of the fourth power conversion module. Alternatively, the first input end may be connected to the output end of the fourth power conversion module, and the second input end may be connected to the output end of the first power conversion module. A first output end of the first power conversion unit is used as the first output end of the third power conversion module, and the first output end of the third power conversion module is connected to the first input end of the container monitoring unit. A second output end of the first power conversion unit is used as a second output end of the third power conversion module, and the second output end of the third power conversion module is connected to an input end of the battery control unit.

The converting the second direct current voltage into the fourth direct current voltage by using the third power conversion module, and supplying power to the container monitoring unit based on the fourth direct current voltage includes: converting the second direct current voltage into the fourth direct current voltage by using the first power conversion unit, and supplying power to the container monitoring unit based on the fourth direct current voltage.

The power supply control method may further include: converting the second direct current voltage into the third direct current voltage by using the first power conversion unit, and supplying power to the battery control unit based on the third direct current voltage.

It may be understood that a same power conversion unit separately supplies power to the container monitoring unit and the battery control unit in the battery management system, which improves power supply efficiency of the battery management system and helps improve stability of the energy storage system. After the power is supplied to the battery control unit, the battery control unit can detect battery rack parameters of battery racks, and control charging and discharging of battery packs in the battery racks based on the battery rack parameters of battery racks, to balance currents and voltages of the battery racks.

In a possible implementation, the battery management system further includes the battery control unit, the third power conversion module includes a second power conversion unit and a third power conversion unit, and input ends of both the second power conversion unit and the third power conversion unit are used as the input end of the third power conversion module, for example, a first input end, a second input end, and the like. An output end of the second power conversion unit is used as the first output end of the third power conversion module, and the first output end of the third power conversion module is connected to the first input end of the container monitoring unit. An output end of the third power conversion unit is used as the second output end of the third power conversion module, and the second output end of the third power conversion module is connected to the input end of the battery control unit.

The converting the second direct current voltage into the fourth direct current voltage by using the third power conversion module, and supplying power to the container monitoring unit based on the fourth direct current voltage includes: converting the second direct current voltage into the fourth direct current voltage by using the second power conversion unit, and supplying power to the container monitoring unit based on the fourth direct current voltage.

The power supply control method may further include: converting the second direct current voltage into the third direct current voltage by using the third power conversion unit, and supplying power to the battery control unit based on the third direct current voltage.

It may be understood that a separate power conversion unit is used to supply power to the container monitoring unit in the battery management system, and a separate power conversion unit is used to supply power to the battery control unit in the battery management system, which helps improve the stability of the energy storage system. After the power is supplied to the battery control unit, the battery control unit can detect the battery rack parameters of the battery racks, and control the charging and the discharging of the battery packs in the battery racks based on the battery rack parameters of the battery racks, to balance the currents and the voltages of the battery racks.

In a possible implementation, the battery management system further includes a battery management unit, and the third power conversion module includes a fourth power conversion unit. An input end of the fourth power conversion unit is used as the input end of the third power conversion module, for example, a first input end, a second input end, and the like. An output end of the fourth power conversion unit is used as a third output end of the third power conversion module, and the third output end of the third power conversion module is connected to an input end of the battery management unit.

The power supply control method may further include: converting the second direct current voltage into the third direct current voltage by using the fourth power conversion unit, and supplying power to the battery management unit based on the third direct current voltage. It may be understood that the fourth power conversion unit in the third power conversion module in the power conversion module may convert the maximum voltage provided by the energy storage module, the direct current bus, and the alternating current mains module or the energy storage converter module into the third direct current voltage output to the battery management unit. Therefore, the battery management unit can operate based on the power supply of the third direct current voltage.

In a possible implementation, the energy storage system further includes a fifth power conversion module. The energy storage module is connected to the direct current bus through the fifth power conversion module. The power supply control method may further include: converting, by using the fifth power conversion module, the direct current voltage output by the energy storage module into a bus voltage required by the direct current bus, so that the energy storage module can supply power to the direct current bus.

An embodiment of this application further provides a chip system. The chip system includes a processor, a memory, and an interface circuit. The memory, the interface circuit, and the processor are interconnected through a line. The memory stores instructions, and when the instructions are executed by the processor, the procedures of the power supply control method for a battery management system are implemented.

An embodiment of this application further provides a computer device, including a memory and a processor connected to the memory. The memory is configured to store a computer program, and the processor is configured to invoke the computer program, so that the computer device performs the power supply control method for a battery management system.

An embodiment of this application further provides a computer-readable storage medium. The computer-readable storage medium stores a computer program. The computer program is suitable for being loaded and executed by a processor, so that a computer device having the processor performs the power supply control method for a battery management system.

An embodiment of this application further provides a computer program product. The computer program product includes computer instructions, and the computer instructions are stored in a computer-readable storage medium. A processor of a computer device reads the computer instructions from the computer-readable storage medium, and the processor executes the computer instructions, so that the computer device performs the the PFC circuit control method.

In conclusion, according to embodiments of this application, at least one power supply device in the direct current bus, the energy storage module, the alternating current mains module, or the energy storage converter module may supply power to the container monitoring unit in the battery management system, thereby improving the reliability of the energy storage system. In addition, the container monitoring unit is first charged by using the small third direct current voltage, so that the charging speed can be improved. Then, the container monitoring unit is charged by using the large fourth direct current voltage, so that the charging efficiency can be improved. After the power supply, the container monitoring unit collects the system parameter of the energy storage system or performs the data transmission with the system controller of the energy storage system, thereby improving the stability of the energy storage system.

A person skilled in the art may clearly understand that, for convenient and brief description, for a detailed operating process of the foregoing apparatus and unit, refer to a corresponding process in the foregoing method embodiments. Details are not described herein again.

In addition, functional units in embodiments of this application may be integrated into one processing unit, each of the units may exist alone physically, or two or more units may be integrated into one unit. The integrated unit may be implemented in a form of hardware, or may be implemented in a form of hardware plus a software functional unit.

It should be noted that, in this application, "at least one" means one or more, and "a plurality of" means two or more. A term "and/or" describes an association relationship between associated objects, and indicates that three relationships may exist. For example, A and/or B may indicate the following three cases: A exists alone, both A and B exist, and B exists alone, where A and B may be singular or plural. In the specification, claims, and accompanying drawings of this application, terms "first", "second", "third", "fourth", and so on (if existent) are intended to distinguish between similar objects but do not indicate a specific order or sequence. In this application, "connection" may refer to a direct connection, an indirect connection, a coupling, or the like. The connection may also be referred to as a coupling, an electrical connection, or the like. This is not limited herein.

Embodiments in this specification are all described in a progressive manner, for same or similar parts in embodiments, refer to these embodiments, and each embodiment focuses on a difference from other embodiments. The method disclosed in embodiments corresponds to the apparatus disclosed in embodiments, and therefore is briefly described. For related parts, refer to the description of the apparatus.

It should be noted that, for brief description, the foregoing method embodiments are represented as a series of actions. However, a person skilled in the art should learn that this application is not limited to the described order of the actions, because according to this application, some steps may be performed in other orders or simultaneously.

A sequence of the steps of the method in embodiments of this application may be adjusted, combined, or removed based on an actual requirement.

The implementations of this application may be randomly combined, to achieve different technical effect.

All or some of the foregoing embodiments may be implemented by using software, hardware, firmware, or any combination thereof. When software is used to implement embodiments, all or some embodiments may be implemented in a form of a computer program product. The computer program product includes one or more computer instructions. When the computer program instruction is loaded and executed on a computer, the procedures or functions according to this application are all or partially generated. The computer may be a general-purpose computer, a dedicated computer, a computer network, or another programmable apparatus. The computer instruction may be stored in a computer-readable storage medium, or may be transmitted from a computer-readable storage medium to another computer-readable storage medium. For example, the computer instruction may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive Solid-State Drive), or the like.

In conclusion, the foregoing descriptions are merely embodiments of the technical solutions of the present invention, but are not intended to limit the protection scope of the present invention. Any modification, equivalent replacement, or improvement made according to the disclosure of the present invention shall fall within the protection scope of the present invention.

## Claims

1. An energy storage system, wherein the energy storage system comprises a direct current bus, an energy storage module, an alternating current mains module, an energy storage converter module, a power conversion module, and a battery management system, wherein the battery management system comprises a container monitoring unit, a first input end of the power conversion module is connected to an output end of the alternating current mains module or an output end of the energy storage converter module, a second input end of the power conversion module is connected to an output end of the direct current bus, a third input end of the power conversion module is connected to an output end of the energy storage module, a first output end of the power conversion module is connected to a first input end of the container monitoring unit, and a second output end of the power conversion module is connected to a second input end of the container monitoring unit;
the power conversion module is configured to convert an alternating current voltage output by the alternating current mains module or an alternating current voltage output by the energy storage converter module into a first direct current voltage;
the power conversion module is further configured to use, as a second direct current voltage, a maximum voltage among a direct current voltage output by the energy storage module, a bus voltage output by the direct current bus, and the first direct current voltage; and
the power conversion module is further configured to: convert the second direct current voltage into a third direct current voltage and a fourth direct current voltage, and separately supply power to the container monitoring unit based on the third direct current voltage and the fourth direct current voltage, wherein the third direct current voltage is less than the fourth direct current voltage.

2. The energy storage system according to claim 1, wherein the power conversion module comprises a first power conversion module, a second power conversion module, and a third power conversion module, input ends of the first power conversion module and the second power conversion module are used as the first input end of the power conversion module, a first output end of the first power conversion module is connected to a first input end of the third power conversion module, an output end of the second power conversion module is used as the second output end of the power conversion module, and a first output end of the third power conversion module is used as the first output end of the power conversion module;
the first power conversion module is configured to: convert the alternating current voltage output by the alternating current mains module or the alternating current voltage output by the energy storage converter module into the first direct current voltage, and supply power to the third power conversion module based on the first direct current voltage;
the second power conversion module is configured to: convert the alternating current voltage output by the alternating current mains module or the alternating current voltage output by the energy storage converter module into the third direct current voltage, and supply power to the container monitoring unit based on the third direct current voltage; and
the third power conversion module is configured to: use, as the second direct current voltage, the maximum voltage among the direct current voltage output by the energy storage module, the bus voltage output by the direct current bus, and the first direct current voltage, convert the second direct current voltage into the fourth direct current voltage, and supply power to the container monitoring unit based on the fourth direct current voltage.

3. The energy storage system according to claim 1, wherein the power conversion module comprises a first power conversion module, a second power conversion module, and a third power conversion module, an input end of the first power conversion module is used as the first input end of the power conversion module, a first output end of the first power conversion module is connected to a first input end of the third power conversion module, a second output end of the first power conversion module is connected to an input end of the second power conversion module, an output end of the second power conversion module is used as the second output end of the power conversion module, and a first output end of the third power conversion module is used as the first output end of the power conversion module;
the first power conversion module is configured to: convert the alternating current voltage output by the alternating current mains module or the alternating current voltage output by the energy storage converter module into the first direct current voltage, and supply power to the second power conversion module and the third power conversion module based on the first direct current voltage;
the second power conversion module is configured to: convert the first direct current voltage into the third direct current voltage, and supply power to the container monitoring unit based on the third direct current voltage; and
the third power conversion module is configured to: use, as the second direct current voltage, the maximum voltage among the direct current voltage output by the energy storage module, the bus voltage output by the direct current bus, and the first direct current voltage, convert the second direct current voltage into the fourth direct current voltage, and supply power to the container monitoring unit based on the fourth direct current voltage.

4. The energy storage system according to claim 2 or 3, wherein the power conversion module further comprises a fourth power conversion module, a first input end of the fourth power conversion module is used as the second input end of the power conversion module, a second input end of the fourth power conversion module is used as the third input end of the power conversion module, and an output end of the fourth power conversion module is connected to a second input end of the third power conversion module;
the fourth power conversion module is configured to convert a larger voltage in the direct current voltage output by the energy storage module and the bus voltage output by the direct current bus into a fifth direct current voltage; and
the third power conversion module is configured to use a maximum voltage in the fifth direct current voltage and the first direct current voltage as the second direct current voltage.

5. The energy storage system according to any one of claims 2 to 4, wherein the battery management system further comprises a battery control unit, the third power conversion module comprises a first power conversion unit, an input end of the first power conversion unit is used as an input end of the third power conversion module, a first output end of the first power conversion unit, used as a second output end of the third power conversion module, is connected to an input end of the battery control unit, and a second output end of the first power conversion unit is used as the first output end of the third power conversion module;
the first power conversion unit is configured to: convert the second direct current voltage into the fourth direct current voltage, and supply power to the container monitoring unit based on the fourth direct current voltage; and
the first power conversion unit is further configured to: convert the second direct current voltage into the third direct current voltage, and supply power to the battery control unit based on the third direct current voltage.

6. The energy storage system according to any one of claims 2 to 4, wherein the battery management system further comprises a battery control unit, the third power conversion module comprises a second power conversion unit and a third power conversion unit, input ends of both the second power conversion unit and the third power conversion unit are used as an input end of the third power conversion module, an output end of the third power conversion unit, used as a second output end of the third power conversion module, is connected to an input end of the battery control unit, and an output end of the second power conversion unit is used as the first output end of the third power conversion module;
the second power conversion unit is configured to: convert the second direct current voltage into the fourth direct current voltage, and supply power to the container monitoring unit based on the fourth direct current voltage; and
the third power conversion unit is configured to: convert the second direct current voltage into the third direct current voltage, and supply power to the battery control unit based on the third direct current voltage.

7. The energy storage system according to claim 5 or 6, wherein the battery management system further comprises a battery management unit, the third power conversion module further comprises a fourth power conversion unit, an input end of the fourth power conversion unit is used as the input end of the third power conversion module, and an output end of the fourth power conversion unit, used as a third output end of the third power conversion module, is connected to an input end of the battery management unit; and
the fourth power conversion unit is configured to: convert the second direct current voltage into the third direct current voltage, and supply power to the battery management unit based on the third direct current voltage.

8. The energy storage system according to any one of claims 2 to 7, wherein the first power conversion module comprises a plurality of power conversion units, and a quantity of power conversion units is greater than a target quantity required by supply power of the energy storage system; and
the first power conversion module is configured to: when a target power conversion unit in the plurality of power conversion units is faulty, convert, based on a power conversion unit other than the target power conversion unit in the plurality of power conversion units, the alternating current voltage output by the alternating current mains module or the alternating current voltage output by the energy storage converter module into the first direct current voltage.

9. The energy storage system according to any one of claims 1 to 8, wherein the energy storage system further comprises a fifth power conversion module, and the energy storage module is connected to the direct current bus through the fifth power conversion module; and
the fifth power conversion module is configured to convert the direct current voltage output by the energy storage module into a bus voltage required by the direct current bus.

10. A power supply control method for a battery management system, wherein the power supply control method is applicable to an energy storage system, the energy storage system comprises a direct current bus, an energy storage module, an alternating current mains module, an energy storage converter module, a power conversion module, and a battery management system, the battery management system comprises a container monitoring unit, a first input end of the power conversion module is connected to an output end of the alternating current mains module or an output end of the energy storage converter module, a second input end of the power conversion module is connected to an output end of the direct current bus, a third input end of the power conversion module is connected to an output end of the energy storage module, a first output end of the power conversion module is connected to a first input end of the container monitoring unit, and the second input end of the power conversion module is connected to a second input end of the container monitoring unit; and
the power supply control method comprises:
converting, by using the power conversion module, an alternating current voltage output by the alternating current mains module or an alternating current voltage output by the energy storage converter module into a first direct current voltage;
using, by using the power conversion module, a maximum voltage among a direct current voltage output by the energy storage module, a bus voltage output by the direct current bus, and the first direct current voltage as a second direct current voltage; and
converting the second direct current voltage into a third direct current voltage and a fourth direct current voltage by using the power conversion module, and separately supplying power to the container monitoring unit based on the third direct current voltage and the fourth direct current voltage, wherein the third direct current voltage is less than the fourth direct current voltage.
